# EUROPEAN PATENT APPLICATION

(11) **EP 2 605 278 A1**
(43) Date of publication of application: **19.06.2013**
(21) Application number: 11193843.7
(22) Date of filing: 15.12.2011
(51) Int. Cl.: H01L 23/495

(54) **Lead Frame with Die Attach Bleeding Control Features**

(71) Applicant: NXP B.V., 5656 AG Eindhoven (NL)
(72) Inventor: Wong, Fei-Ying, 5656 AG Eindhoven (NL); Walczyk, Sven, 5656 AG Eindhoven (NL); Umali, Pompeo, 5656 AG Eindhoven (NL); Boettcher, Tim, 5656 AG Eindhoven (NL); Groenhuis, Roelf Anco Jacob, 5656 AG Eindhoven (NL); Lee, SteveChiFai, 5656 AG Eindhoven (NL); Tsang, Paulpanghing, 5656 AG Eindhoven (NL); Noren, Markus Björn Erik, 5656 AG Eindhoven (NL); Rohrmoser, Bernd, 5656 AG Eindhoven (NL); Shum, Chiling, 5656 AG Eindhoven (NL)
(74) Representative: Krott, Michel

(57) **Abstract**

Consistent with an example embodiment, a lead frame is configured to accommodate an electronic device of a size. The lead frame comprises a die attach pad upon which an electronic device is mounted; a distance between edges of the mounted electronic device and edges of the die attach pad defines a boundary clearance. A plurality of cavities is defined on the periphery of the die attach pad, about the edge of the boundary clearance, the size of the cavities determined by the size of the electronic device mounted on the die attach pad. During die attach, the plurality of cavities serves to contain the die attach material on the die attach pad within the boundary clearance.

## Description

### FIELD OF INVENTION

The embodiments of the present invention relate to semiconductor device packaging and, more particularly, to packaging having modifications that enhance the manufacturability and quality of products.

### BACKGROUND OF THE INVENTION

The electronics industry continues to rely upon advances in semiconductor technology to realize higher-function devices in more compact areas. For many applications realizing higher-functioning devices requires integrating a large number of electronic devices into a single silicon wafer. As the number of electronic devices per given area of the silicon wafer increases, the manufacturing process becomes more difficult.

Many varieties of semiconductor devices have been manufactured having various applications in numerous disciplines. Such silicon-based semiconductor devices often include metal-oxide-semiconductor field-effect transistors (MOSFET), such as p-channel MOS (PMOS), n-channel MOS (NMOS) and complementary MOS (CMOS) transistors, bipolar transistors, BiCMOS transistors. Such MOSFET devices include an insulating material between a conductive gate and silicon-like substrate; therefore, these devices are generally referred to as IGFETs (insulated-gate FET).

Each of these semiconductor devices generally includes a semiconductor substrate on which a number of active devices are formed. The particular structure of a given active device can vary between device types. For example, in MOS transistors, an active device generally includes source and drain regions and a gate electrode that modulates current between the source and drain regions.

Furthermore, such devices may be digital or analog devices produced in a number of wafer fabrication processes, for example, CMOS, BiCMOS, Bipolar, *etc.* The substrates may be silicon, gallium arsenide (GaAs) or other substrate suitable for building microelectronic circuits thereon.

The packaging of an IC device is increasingly playing a role in its ultimate performance. Shortcomings in a particular package configuration may challenge the die-attach process. For example, an IC component is placed onto to the die-attach pad the material used to attach the die oozes out from under the die. This phenomenon is known as "over bleeding," and may contribute to package de-lamination or excessive device current leakage.

There is exists a need for a chip carrier with increased manufactur-ability and less susceptibility to over bleeding.

### SUMMARY OF INVENTION

In the die-attaching of electronic devices to chip carriers, the user has to assure that a sufficient amount of die-attach material is applied so that the die has good mechanical adhesion to the die attach pad, yet the amount of die attach material must not be excessive so as to bleed out and make undesirable contact with other features of the chip carrier (i.e., conductive traces, *etc*.).

The present disclosure outlines the configuration of a chip carrier with a die attach area upon which an integrated circuit (IC) die is mounted. The die may be mounted via a solder-based bonding (*eg*., eutectic bonding that may use gold-tin or gold-silicon solder) or be glued on with a die-attach adhesive. In each of these examples, there may be an over-bleed of die attach material. To prevent the over bleed, the die attach area may have cavities defined thereon; the cavities may located in the vicinity of the edge of the die or underneath the die as the die is attached. The placement of the cavities on the chip carrier is governed by the size of the die a particular chip carrier is designed to receive.

The chip carriers may include, but are not limited to, bump chip carrier (BCC) ball-grid array (BGA), dual inline package (DIP), column grid array (CGA), pin grid array (PGA), leadless chip carrier (LCC), quad flat pack (QFP), small outline diode (SOD), small outline package (SOP), *etc.* Such chip carriers may be made of ceramic or plastic molding compounds, depending upon the application. For example, high performance military components may use ceramic packaging versus lower-cost consumer components that may use plastic packages. The die attach area in any of these packages may be modified in accordance with the present disclosure.

In an example embodiment, a lead frame is configured to accommodate an electronic device of a size. The lead frame comprises a die attach pad upon which an electronic device is mounted; a distance between edges of the mounted electronic device and edges of the die attach pad defines a boundary clearance. A plurality of cavities is defined on the periphery of the die attach pad, about the edge of the boundary clearance, the size of the cavities determined by the size of the electronic device mounted on the die attach pad. In another example embodiment, a packaged semiconductor device comprises a device die having an active circuit region. Coupled to the active circuit region is a plurality of die pad landings. Further, a package includes a package boundary defining an interior portion of the package and an exterior portion of the package; within the interior portion of the package is a die attach region, whereupon the device die is mounted. The die attach region includes a plurality of cavities defined therein; the plurality of cavities is configured and arranged for containment for die attach material. There is a plurality of bonding pads, each of the plurality of bonding pads coupled to corresponding device die pad landings. A plurality of external terminals is configured and arranged about the exterior portion of the package and coupled to the plurality bonding pads for electrically connecting to the active circuit region of the packaged semiconductor device.

The above summaries of the present disclosure are not intended to represent each disclosed embodiment, or every aspect, of the present invention. Other aspects and example embodiments are provided in the figures and the detailed description that follow.

### BRIEF DESCRIPTION OF THE DRAWINGS

The invention may be more completely understood in consideration of the following detailed description of various embodiments of the invention in connection with the accompanying drawings, in which:
Fig. 1A (Prior Art) depicts a plain die attach pad;
Fig. 1B (Prior Art) depicts an example die having been attached to the die attach pad of Fig. 1A, the die attach material exhibiting over bleeding; and
Fig. 2A is a line drawing of an example embodiment of a lead frame having a die attach pad according to the present disclosure;
Fig. 2B is a line drawing of another example embodiment of a lead frame having a die attach pad according to the present disclosure;
Fig. 3A depicts an example embodiment of a lead frame having an additional cavity in the shape of an "X;"
Fig. 3B depicts another example embodiment of a lead frame having cavity n the shape of a ring;
Fig. 3C depicts an example of a lead frame having a cavity with a pair of oblong structures;
Fig. 4A shows an example lead frame of example embodiment of the present disclosure;
Fig. 4B shows the example lead frame with a die attached thereon and the lack of die attach material over bleed; and
Fig. 4C shows the example lead frame with die removed, the cavities having collected die attach material.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the spirit and scope of the invention as defined by the appended claims.

### DETAILED DESCRIPTION OF THE EMBODIMENTS

The disclosed embodiments have been found useful in reducing the likelihood of over bleeding of die attach material when an electronic device is mounted onto a chip carrier. The over bleeding of die attach material may affect device performance in that undesirable current leakage paths may be created or that the mechanical integrity of the packaging may be threatened. The die may range in size from a two-terminal diode chip to a complex IC chip having upwards of a thousand pins with a concomitant increase in die size. Furthermore, in some applications multiple device die may be attached to multiple die attached locations situated within a single package (i.e., "hybrid devices," system-in-package, *etc*.).

The placement of the cavities on a chip carrier may be underneath the die or around the periphery of the die. The cavity's size would be governed by the die size; a larger die would require more die attach material than that of a smaller die. The cavity would serve as a reservoir to capture the die attach material and prevent the die attach material from over bleeding. The cavity would further serve to enhance the mechanical attachment of the die to the chip carrier.

In an example embodiment, a chip carrier is configured with a die-attach area upon which an integrated circuit (IC) die is mounted. The die may be mounted via a solder-based bonding (e.g., eutectic bonding that may use gold-tin or gold-silicon solder) or be glued on with a die-attach adhesive. In each of these examples, there may be an over-bleed of die attach material. To prevent the over bleed, the die-attach area may have cavities defined thereon; the cavities may be located in the vicinity of the edge of the die or underneath the die as the die is attached. The placement of the cavities on the chip carrier is governed by the size of the die a particular chip carrier is designed to receive.

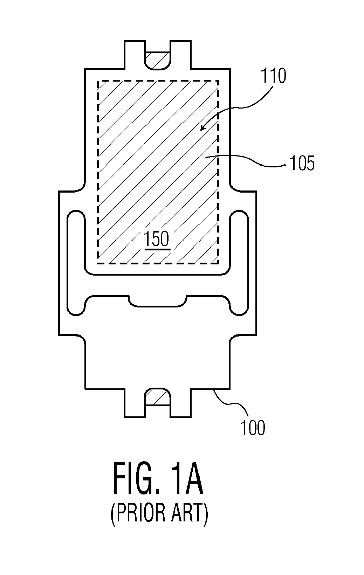

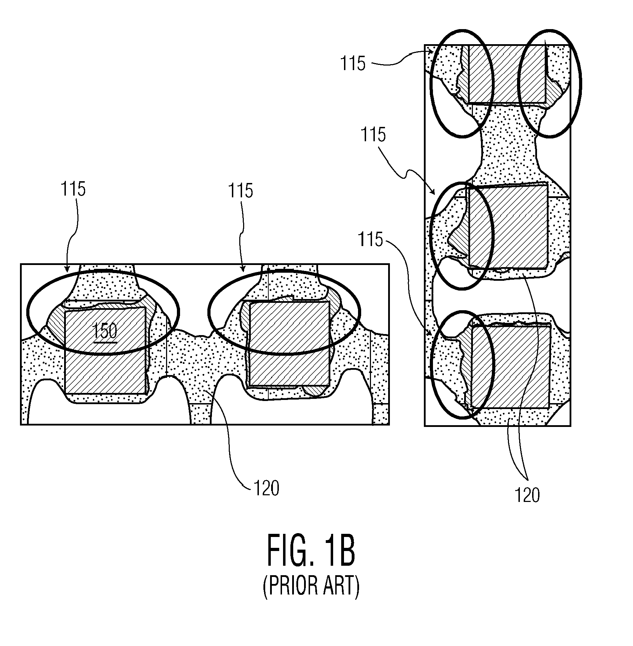

In reference to Figs. 1A-1B, an example lead frame 100, a die 150 is mounted onto die-attach pad 110. The die-attach material 115 over bleeds onto the nearby traces 120. The final assembled product may exhibit a loss of quality (e.g., package de-lamination, current leakage, *etc*.).

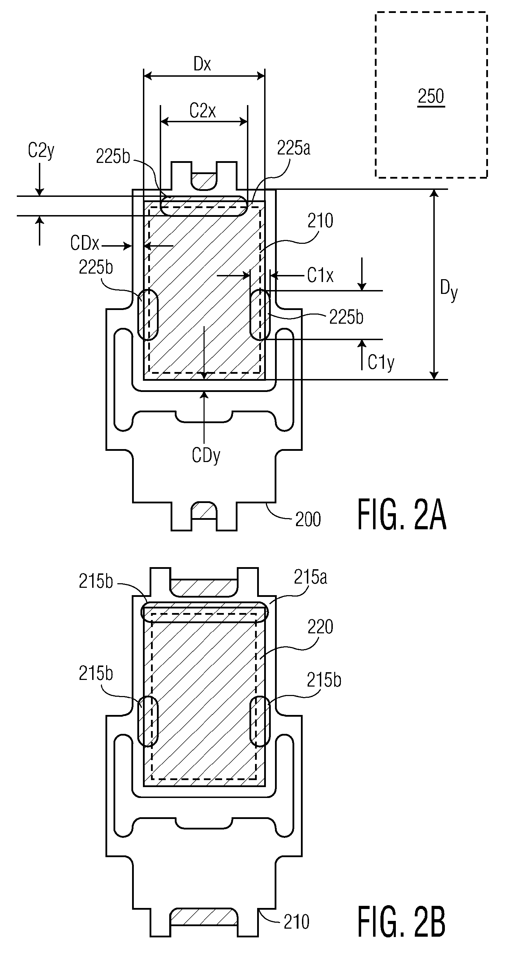

In reference to Fig. 2A, in an example embodiment, a lead frame 200 has three cavities 225 laid out along the periphery of the die 250 mounted thereon. One cavity 225a runs along the width of die 250; two cavities 225b run along the length of the die 205 opposite and perpendicular to cavity 224a. In reference to Fig. 2B, in another lead frame 210, three cavities 215 also are laid out along the periphery of die 205, placed thereon. One cavity 215a has a length comparable to the width of the die 205; the other cavities 215b are oriented similar to those in Fig. 2A. As a die is mounted, the cavities serve to act as a reservoir and as a stopper to prevent the die-attach material from over-bleeding. These cavities may either be stamped into or half-etched into the lead frames during their manufacture. Half-etching refers to etching the depth of the cavity feature to about one-half of the material thickness, in this case, the lead frames 200 and 210.

For an example process, the size of a cavity depends on the clearance between (i.e., a boundary clearance) die edge to the die pad edge, the machine and process capability (e.g., glue viscosity, machine accuracy). The cavity size is independent of the die size. As soon as the clearance becomes critically small, these reservoirs are helpful to limit the glue bleeding. In one example process, this critical clearance between the die pad edge and the die edge would be about 50 µm. The size of the cavities range from about 10µm to about 200µm. However, this depends on the material and process capabilities (e.g. glue viscosity, machine accuracy). Table I discloses some dimensions for a specific example lead frame and device die.

Note the critical clearances CDₓ and CD_{y} for both X and Y directions as the boundary clearances approach 50 µm.

| **Table I. Example Lead Frame Dimensions** | | | |
|---|---|---|---|
| Description of Dimension | Symbol | Example Length (mm) | Example Length (µm) |
| Die Size X-Direction | Dₓ | 0.42 | 420 |
| Die Size Y-Direction | D_{y} | 0.85 | 850 |
| 1st Cavity X-Direction | C1ₓ | 0.09 | 90 |
| 1st Cavity Y-Direction | C1_{y} | 0.24 | 240 |
| 2^{nd} Cavity X-Direction | C2ₓ | 0.42 | 420 |
| 2^{nd} Cavity Y-Direction | C2_{y} | 0.09 | 90 |
| Die Edge-to-Die Pad Edge Distance (Boundary Clearance) X-Direction | CDₓ | >= 0.05 | >=50 |
| Die Edge-to-Die Pad Edge Distance (Boundary Clearance) Y-Direction | CD_{y} | >=0.05 | >=50 |

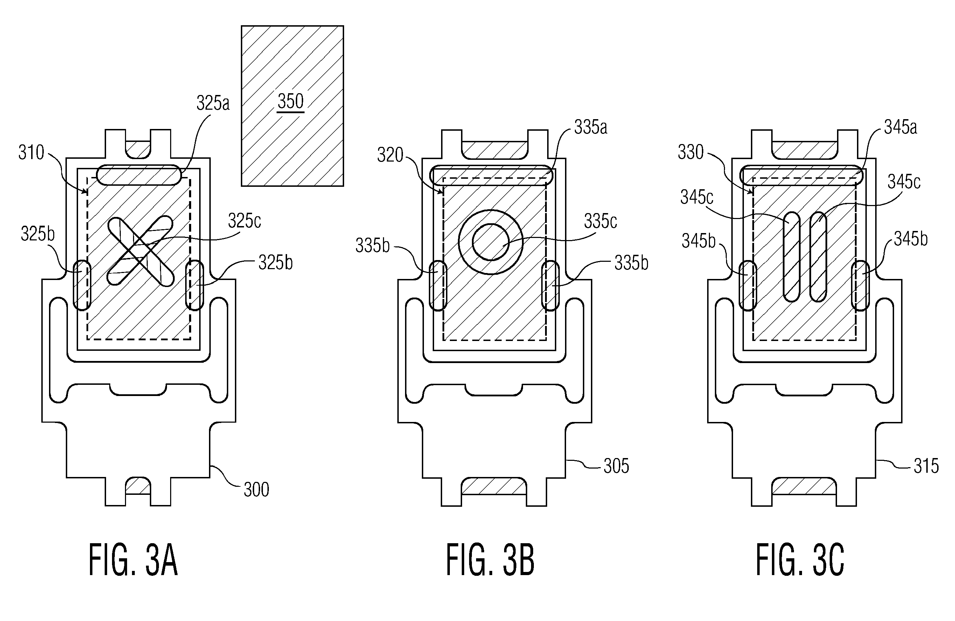

In reference to Figs. 3A-3B, in other example embodiments, an IC die 350 may be mounted in three packages having cavities defined in the center region of the die attach area therein so as to prevent over bleed of the die attach material. In Fig. 3A, for a lead frame 300, in addition to the peripheral cavities 325a and 325b, and additional cavity 325c may be defined as an "X-structure" in the center region of die-attach area 310. Likewise, in Fig. 3B, for a lead frame 305, in addition to the peripheral cavities 335a and 335b, a ring-like cavity in the center region of the die-attach area 320. Similarly, in Fig. 3C, for a lead frame 315 in addition to peripheral cavities 345a and 345b, a pair of oblong cavities 345c may be defined in the center of die attach region 330. These example embodiments may have dimensions similar to that of Fig. 2A and Table I.

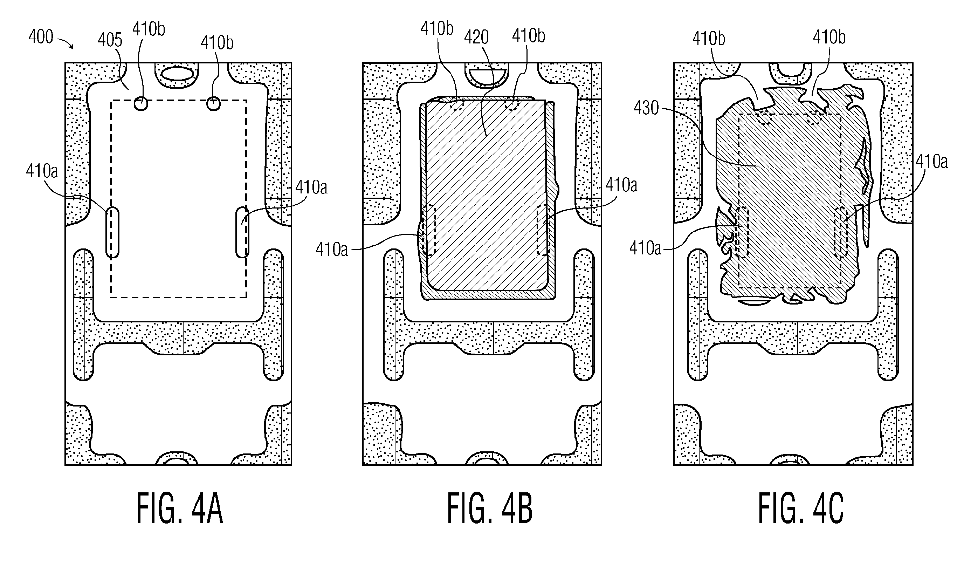

In reference to Figs. 4A - 4C, in another example embodiment, a series of photographs show a lead frame having cavities defined therein. Fig. 4A shows a bare lead frame 400 having a die attach area 405 (shown with dashed lines) and cavities 410a, 410b. Fig. 4B shows a device 420 bonded on the die attach area 405. Fig. 4C shows the lead frame 400 with the bonded device 420 removed. The cavities 410a and 410b have collected any excess die attach material 430, resulting in lower likelihood of die attach material over bleed.

In other example packages, the defining of cavities according to the present disclosure is determined by the particular characteristics of the package type, the die size, and form of die attach. In the afore-mentioned discussion, these cavities may be defined in the die attach areas of other types of packages. Furthermore, additional shapes that differ from those discussed herein, may also be defined in the die-attach area of a given package type.

Numerous other embodiments of the invention will be apparent to persons skilled in the art without departing from the spirit and scope of the invention as defined in the appended claims.

## Claims

1. A lead frame configured to accommodate an electronic device of a size, the lead frame comprising:
a die attach pad upon which an electronic device is mounted;
a distance between edges of the mounted electronic device and edges of the die attach pad defining a boundary clearance; and
a plurality of cavities defined on the periphery of the die attach pad, about the edge of the boundary clearance, the size of the cavities determined by the size of the electronic device mounted on the die attach pad.

2. The lead frame as recited in claim 1, wherein the plurality of cavities is defined by at least one of the following:
half-etching of cavity features in the lead frame;
stamping of cavity features in the lead frame.

3. The lead frame as recited in claim 1, wherein the size of the cavities is further determined by an amount of die attach material sufficient to cover the underside area of the electronic device mounted on the die attach pad.

4. The lead frame as recited in claim 1, wherein the plurality of cavities is further defined at the center of the die attach pad.

5. The lead frame as recited in claim 4, wherein a shape of the cavities at the center of the die attach pad comprises, at least one of the following:
an X pattern,
a ring pattern, and
a number of oblong shapes.

6. A packaged semiconductor device comprising:
a device die having an active circuit region;
a plurality of die pad landings coupled to the active circuit region;
a package including,
a package boundary defining an interior portion of the package and an exterior portion of the package;
a die-attach region within the interior portion of the package, whereupon, the device die is mounted,
wherein, the die-attach region includes a plurality of cavities defined therein,
wherein, the plurality of cavities is configured and arranged for containment for die attach material;
a plurality of bonding pads, each of the plurality of bonding pads coupled to corresponding device die pad landings;
a plurality of external terminals configured and arranged about the exterior portion of the package and coupled to the plurality bonding pads for electrically connecting to the active circuit region of the packaged semiconductor device.

7. The packaged semiconductor device as recited in claim 6, wherein the die attach region further includes,
a die attach pad upon which the device die is mounted,
wherein a distance between edges of the mounted device die and edges of the die attach pad defines a boundary clearance; and
the plurality of cavities are defined on the periphery of the die attach pad, about the edge of the boundary clearance, the size of the cavities being determined by the size of the device die mounted on the die attach pad.

8. The packaged semiconductor device as recited in claim 7, wherein the size of the cavities is further determined by an amount of die attach material sufficient to substantially cover the underside area of the electronic device mounted on the die attach pad.

9. The packaged semiconductor device as recited in claim 6, where in the boundary clearance approaches a critical clearance.

10. The packaged semiconductor device as recited in claim 9, wherein the critical clearance is greater than equal to approximately 50µm and less than 100µm.

11. The packaged semiconductor device as recited in claim 10, wherein the critical clearance is approximately 50µm and less than 75 µm.

12. The packaged semiconductor device, as recited in claim 11, wherein the critical clearance is approximately 50µm.
